# EUROPEAN PATENT APPLICATION

(11) **EP 4 749 353 A1**
(43) Date of publication of application: **27.05.2026**
(21) Application number: 24878644.4
(22) Date of filing: 12.08.2024
(51) Int. Cl.: G02B 30/36, H04N 13/00, H10K 59/10

(54) **DISPLAY SCREEN AND ELECTRONIC DEVICE**

(30) Priority: 16.10.2023 CN 202311343267
(71) Applicant: Honor Device Co., Ltd., Shenzhen, Guangdong 518040 (CN)
(72) Inventor: CAI, Peizhi, Shenzhen, Guangdong 518040 (CN)
(74) Representative: Epping - Hermann - Fischer
(86) International application number: PCT/CN2024/111393
(87) International publication number: WO 2025/081992

(57) **Abstract**

This application relates to the field of display technologies, and provides a display and an electronic device. The display includes: a display panel, where the display panel includes at least a first display pixel and a second display pixel; a collimation layer, where the collimation layer is stacked on the display panel in a first direction, and configured to collimate light emitted by the first display pixel into first collimated light and light emitted by the second display pixel into second collimated light; and a first deflecting element and a second deflecting element, where the first deflecting element is stacked on the collimation layer and configured to perform first deflection on the first collimated light, the second deflecting element is stacked on the collimation layer and configured to perform second deflection on the second collimated light, and a deflected light direction of the first deflection is different from that of the second deflection; and materials of the first deflecting element and the second deflecting element are materials supporting formation that is implemented by using a patterning process. According to this application, a thickness of the display can be reduced, and precision of alignment between the deflecting elements and the display pixels can be improved.

## Description

This application claims priority to Chinese Patent Application No. 202311343267.6, filed with the China National Intellectual Property Administration on October 16, 2023 and entitled "DISPLAY AND ELECTRONIC DEVICE", which is incorporated herein by reference in its entirety.

### TECHNICAL FIELD

This application relates to the field of display technologies, and in particular, to a display and an electronic device.

### BACKGROUND

A glasses-free 3D technology can enable users to view videos or images with stereoscopic visual effect without external tools (for example, polarized glasses). Usually, glasses-free 3D display effect can be implemented by using a display with a specific structure. However, in the conventional technology, to implement the glasses-free 3D display effect, the display has a large thickness.

### SUMMARY

This application provides a display and an electronic device including the display, to implement a small thickness while implementing glasses-free 3D display effect.

According to a first aspect, this application provides a display. The display includes: a display panel, where the display panel includes at least a first display pixel and a second display pixel; a collimation layer, where the collimation layer is stacked on the display panel in a first direction, and configured to collimate light emitted by the first display pixel into first collimated light and light emitted by the second display pixel into second collimated light; and a first deflecting element and a second deflecting element, where the first deflecting element is stacked on the collimation layer in the first direction and configured to perform first deflection on the first collimated light, the second deflecting element is stacked on the collimation layer and configured to perform second deflection on the second collimated light, and a deflected light direction of the first deflection is different from that of the second deflection; and materials of the first deflecting element and the second deflecting element are materials supporting formation that is implemented by using a patterning process.

According to this implementation of this application, the deflecting elements may be formed by using the patterning process, significantly reducing a thickness of the display. In addition, due to high production precision of the patterning process, precision of alignment between the deflecting elements and the display pixels can be high in this application.

In some implementations, the collimation layer is configured to collimate, along the first direction, the light emitted by the first display pixel and the second display pixel.

In some implementations, a deflection plane of the first deflection and a deflection plane of the second deflection overlap each other or are parallel to each other.

In some implementations, the first deflection causes the first collimated light to deviate from the first direction towards a second direction, the second deflection causes the second collimated light to deviate from the first direction towards a direction opposite the second direction, and the second direction is perpendicular to the first direction and parallel to a deflection plane of the first deflection.

In some implementations, the display panel further includes a third display pixel and a fourth display pixel; the first display pixel, the second display pixel, the third display pixel, and the fourth display pixel are aligned in a third direction; and the third direction is perpendicular to the first direction, where light emitted by the third display pixel and the fourth display pixel and emerging out of the display is scattered light; or the collimation layer is further configured to collimate light emitted by the third display pixel and the fourth display pixel, so that the light emitted by the third display pixel and the fourth display pixel and emerging out of the display is parallel light that is parallel to each other.

According to this implementation of this application, the display can further switch between a 3D mode and a 2D mode.

In some implementations, the first display pixel, the third display pixel, the second display pixel, and the fourth display pixel are arranged sequentially in the third direction.

In some implementations, a deflection plane of the first deflection and a deflection plane of the second deflection overlap each other or are parallel to each other; and the third direction is parallel to the deflection plane of the first deflection, or the third direction is at an angle of 45° to the deflection plane of the first deflection.

In some implementations, a material of the collimation layer is a material supporting formation that is implemented by using the patterning process.

In some implementations, the collimation layer includes a first collimating element and a second collimating element, and the collimation layer collimates the light emitted by the first display pixel by using the first collimating element, and collimates the light emitted by the first display pixel by using the second collimating element.

In some implementations, the first collimating element and the second collimating element are collimating lenses, or the first collimating element and the second collimating element are collimating films.

In some implementations, the first deflecting element and the second deflecting element are diffractive elements, or the first refractive element and the second refractive element are refractive elements.

In some implementations, the diffractive element is a grating, and the refractive element is a prism.

In some implementations, the grating is a transmissive grating. According to this application, light output efficiency of the display can be improved.

In some implementations, the display panel is an organic light-emitting diode OLED panel.

According to a second aspect, this application provides an electronic device. The electronic device includes a housing and the display according to any one of the implementations of the first aspect in this application. The display is disposed on the housing. For technical effects of the second aspect in this application, refer to the technical effects of any one of the implementations of the first aspect in this application. Details are not described again.

### BRIEF DESCRIPTION OF DRAWINGS

FIG. 1 is a diagram of an example structure of an electronic device according to an embodiment of this application;
FIG. 2A is a diagram of an example structure of a display according to an embodiment of this application;
FIG. 2B is a diagram of an example structure of a display layer according to an embodiment of this application;
FIG. 3 is a diagram 1 of a pixel array of a display according to an embodiment of this application;
FIG. 4 is a diagram 2 of a pixel array of a display according to an embodiment of this application;
FIG. 5 is a diagram of principles of glasses-free 3D display according to an embodiment of this application;
FIG. 6A is a diagram 1 of a structure of a display layer according to an embodiment of this application (3D mode);
FIG. 6B is a diagram 2 of a structure of a display layer according to an embodiment of this application (2D mode);
FIG. 7A is a diagram 1 of a display solution of a display according to an embodiment of this application;
FIG. 7B is a diagram 2 of a display solution of a display according to an embodiment of this application;
FIG. 8A is a diagram 3 of a structure of a display layer according to an embodiment of this application (3D mode);
FIG. 8B is a diagram 4 of a structure of a display layer according to an embodiment of this application (2D mode);
FIG. 9A is a diagram 5 of a structure of a display layer according to an embodiment of this application (3D mode);
FIG. 9B is a diagram 6 of a structure of a display layer according to an embodiment of this application (2D mode);
FIG. 10A is a diagram 7 of a structure of a display layer according to an embodiment of this application (3D mode);
FIG. 10B is a diagram 8 of a structure of a display layer according to an embodiment of this application (2D mode);
FIG. 10C is a diagram 9 of a structure of a display layer according to an embodiment of this application (3D mode);
FIG. 10D is a diagram 10 of a structure of a display layer according to an embodiment of this application (2D mode);
FIG. 11A is a diagram of a structure of a display according to an embodiment; and
FIG. 11B is a diagram of a structure of a display according to another embodiment.

### DESCRIPTION OF EMBODIMENTS

The following describes specific implementations of this application in detail with reference to the accompanying drawings.

Embodiments of this application are used to provide a display and an electronic device including the display, so that the display can have a small thickness while implementing glasses-free 3D display effect.

In this application, the electronic device may be a device with a display function such as a mobile phone, a notebook computer, a tablet, a large-screen device, a wearable device (for example, a watch, smart glasses, or a helmet), an augmented reality (Augmented Reality, AR)/virtual reality (Virtual Reality, VR) device, or a personal digital assistant (Personal Digital Assistant, PDA). This is not limited in this application. The following uses a tablet as an example of an electronic device 100.

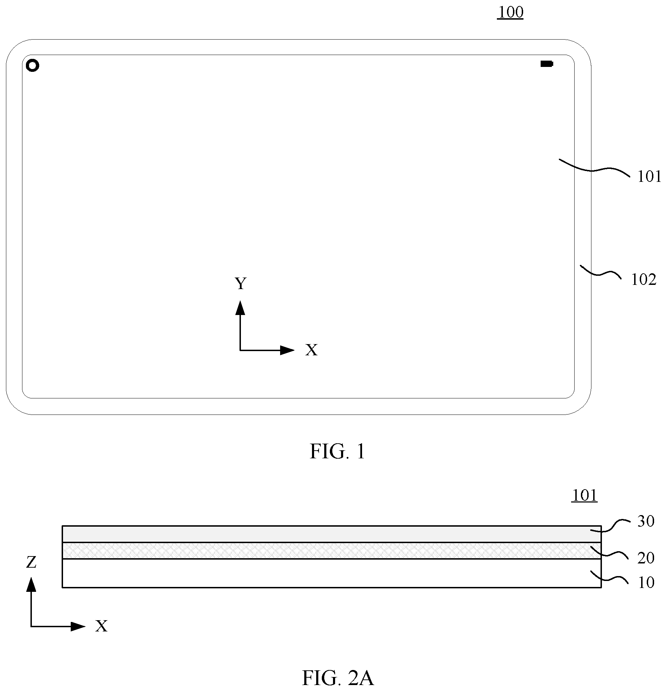

FIG. 1 is a diagram of an example structure of the electronic device 100 according to an embodiment of this application. In the drawings in this specification, an X-axis direction is a length direction of the electronic device 100 (a direction from a left side of the electronic device 100 to a right side is positive, used as an example of a second direction), a Y-axis direction is a width direction of the electronic device 100 (a direction from a bottom of the electronic device 100 to a top is positive), and a Z-axis direction is a thickness direction of the electronic device 100 (a direction from a back of the electronic device 100 to a front is positive, used as an example of a first direction). Any two of the X-axis direction, the Y-axis direction, and the Z-axis direction may be perpendicular to each other. In addition, unless particularly specified, the X-axis direction, the Y-axis direction, and the Z-axis direction refer to positive directions of an X-axis, a Y-axis, and a Z-axis, respectively.

In addition, it may be understood that in FIG. 1, the electronic device 100 is in a landscape orientation. During actual use, the electronic device 100 may alternatively be in a portrait orientation, that is, an orientation in which the electronic device 100 is after the electronic device 100 is rotated by 90° clockwise from the orientation shown in FIG. 1.

With reference to FIG. 1, the electronic device 100 includes a display 101 and a housing 102. The display 101 is disposed on the housing 102. The electronic device 100 may implement its display function by using the display 101, for example, displaying an application screen, a boot screen, and an unlock screen. In some embodiments, the display 101 of the electronic device 100 further provides a touch function, that is, a user can enter data, instructions, and the like by touching the display 10.

FIG. 2A is a diagram of a structure of the display 101 (a diagram of a section of an X-Z plane). With reference to FIG. 2A, the display 101 may be of a multi-layer structure, and includes a display layer 10, a touch layer 20, and a glass cover plate 30 that are stacked sequentially from bottom to top. The display layer 10 is configured to display images (for example, 2D images and 3D images). The touch layer 20 is configured to provide the touch function of the display 101. The glass cover plate 30 is configured to provide protection for a lower-layer structure of the display 101, for example, protection against moisture, protection against dust, and mechanical protection. It should be noted that FIG. 2A merely illustrates an example of the display 101. In another embodiment, the display 101 may include more or fewer layers. For example, the display 101 may not include the touch layer 20.

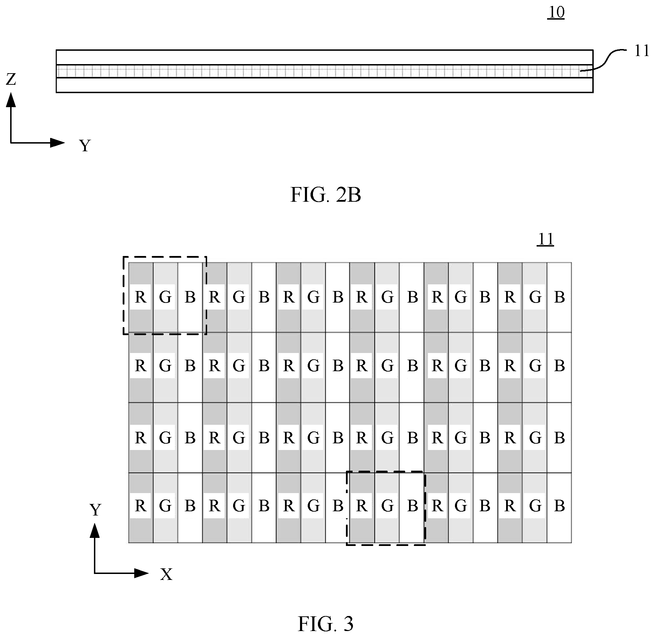

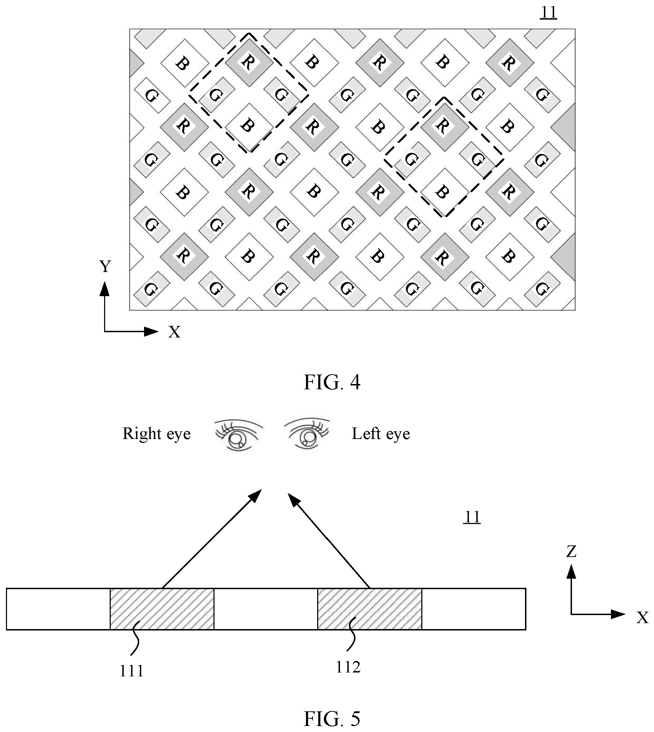

Specifically, with reference to FIG. 2B, the display layer 10 includes a display panel 11. The display layer 10 implements its image display function by using the display panel 11. FIG. 3 and FIG. 4 show two example structures of the display panel 11 (front views). With reference to FIG. 3 and FIG. 4, the display panel 11 includes a plurality of display pixels (referred to as "pixels" for short). Each pixel includes a plurality of sub-pixels. For ease of observation, in FIG. 3 and FIG. 4, sub-pixels in a same dashed-line box belong to a same pixel. Different sub-pixels of a same pixel may display three different colors respectively: red (Red, R), green (Green, G), and blue (Blue, B). The display 101 may be controlled to display a particular image by controlling display parameters of the pixels (for example, display luminance of the sub-pixels). It may be understood that in another embodiment, the display pixels may be alternatively set in another manner. For example, the sub-pixels of the display pixels may display other colors.

The plurality of display pixels of the display panel 11 may be arranged in an array. For example, in FIG. 3, the plurality of display pixels are arranged in a rectangular array, that is, a row direction of pixel arrangement is parallel to the X-axis direction, and a column direction is parallel to the Y-axis direction. The pixel array shown in FIG. 3 may be referred to as a strip (Strip) array. In FIG. 4, the plurality of display pixels are arranged in a rhombus array, that is, a row direction of pixel arrangement is at an angle of 45° to the X-axis direction. The pixel array shown in FIG. 4 may be referred to as a delta array. In other embodiments, the pixels may be alternatively arranged in other manners, for example, pentile arrangement. The manners are not described in detail one by one.

The following describes principles of a glasses-free 3D display technology. Because there is a specific distance between the left and right eyes of a person, images observed by the left and right eyes are different. After the images observed by the left and right eyes are fused in the brain, the person can experience stereoscopic visual effect. Based on the principles, two cameras located in different positions are used for shooting, with one located at a position of the left eye of a person (an image shot is referred to as a "left-eye image"), and the other at a position of the right eye of the person (an image shot is referred to as a "right-eye image"). Subsequently, after the left-eye image is projected into the left eye of a user, and the right-eye image is projected into the right eye of the user, the user can observe stereoscopic visual effect.

FIG. 5 is an example diagram of principles of implementing glasses-free 3D display by using the display 101. With reference to FIG. 5, the display panel 11 includes a pixel 112 configured to display left-eye images (or referred to as a "left-eye pixel") and a pixel 111 configured to display right-eye images (or referred to as a "right-eye pixel"). After directions of light emitted by the pixel 112 and the pixel 111 are controlled, that is, the light emitted by the pixel 112 is controlled to be incident on the left eye of a user, and the light emitted by the pixel 111 is controlled to be incident on the right eye of the user, the user can experience stereoscopic visual effect.

For example, the directions of the light may be controlled by an optical element such as a nano-diffractive grating, a TN liquid crystal grating, or a liquid crystal lens, to implement 3D display effect of the display 101.

For example, in some embodiments, the display panel of the display is a liquid crystal display (Liquid Crystal Display, LCD) panel without a self-light-emitting function. The display is provided with a nano-diffractive grating (referred to as a "grating" for short hereinafter) between the LCD panel and a backlight module of the display. When the display performs 3D display, collimated backlight is coupled into the grating from a side of the grating. At positions corresponding to 3D pixels of the LCD panel, the backlight coupled into the grating emerges out of the grating through transmissive diffraction. At remaining positions, the backlight coupled into the grating continues to propagate forward in the grating through reflective diffraction. In this embodiment, when positions and angles at which light emerges out of the grating are controlled, light from left-eye pixels of the display panel can be incident on the left eye of a user, and light from right-eye pixels of the display panel can be incident on the right eye of the user, implementing glasses-free 3D display effect of the display. However, in this embodiment, due to addition of the nano-diffractive grating between the backlight module and the LCD panel, an overall thickness of the display is large (for example, the thickness is at least 1 mm). In addition, at the positions not corresponding to the 3D pixels of the LCD panel, the light does not emerge out of the grating through transmission. Therefore, light output efficiency of the display 101 is low (for example, the light output efficiency is at most 50%).

For another example, in some other embodiments, the display panel of the display is still an LCD panel. The display is provided with a TN liquid crystal grating between the LCD panel and a backlight module of the display. When positions at which light emerges out of the TN liquid crystal grating and angles at which the TN liquid crystal grating refracts light emitted by the backlight module are controlled, glasses-free 3D display effect of the display can be implemented. In this embodiment, due to addition of the liquid crystal grating between the backlight module and the LCD panel, an overall thickness of the display is also large (for example, the thickness is at least 1 mm). In addition, at positions not corresponding to 3D pixels of the LCD panel, the light does not emerge out of the TN liquid crystal grating either. Therefore, light output efficiency of the display is also low (for example, the light output efficiency is at most 50%).

For another example, in some other embodiments, the display panel of the display is an organic light-emitting diode (Organic Light-Emitting Diode, OLED) display panel with a self-light-emitting function. The display is provided with a liquid crystal lens on its OLED panel. When angles at which the liquid crystal lens refracts light emitted by the OLED panel are controlled, 3D display effect of the display can be implemented. However, due to a large thickness of the liquid crystal lens, an overall thickness of the display is also large (for example, the thickness is at least 1 mm).

In view of this, an embodiment of this application provides a display, to reduce an overall thickness of the display. Specifically, in this embodiment, a collimation layer and a deflecting element layer are stacked on 3D display pixels (including a left-eye pixel and a right-eye pixel) of a display panel. The collimation layer is configured to collimate light emitted by the 3D display pixels of the display panel, to collimate the light emitted by the 3D display pixels from scattered light into parallel light. The deflecting element layer is configured to deflect the collimated light, so that the light corresponding to the left-eye pixel can be incident on the left eye of a user, and the light corresponding to the right-eye pixel can be incident on the right eye of the user, implementing 3D display effect of the display. Materials of deflecting elements are materials supporting formation that is implemented by using a patterning process (which may also be referred to as a "MASK process"). In other words, the deflecting elements may be formed by using the patterning process. The patterning process is a process of removing, by performing a series of steps (for example, photoresist application, exposure, development, and etching), specific portions of a thin film deposited on a surface of a substrate. After the patterning process is complete, a specific pattern may be formed on the thin film, for example, a strip of a specific width or a curved surface in a specific shape.

Because the patterning process can implement formation on a quite thin film, when the deflecting elements are formed by using the patterning process, thicknesses of the deflecting elements can be reduced significantly. For example, the thicknesses of the deflecting elements can be reduced to a micrometer level. As such, a thickness of an entire display layer can be reduced significantly. For example, the thickness of the display layer is reduced to about 0.1 µm to 10 µm. Because the overall thickness of the display layer is small, after the display is mounted on an electronic device, an overall thickness of the electronic device hardly increases. This has particularly important application value for an electronic device that has a high requirement for being lighter and thinner (for example, a mobile phone).

In addition, the patterning process has high production precision. When the deflecting elements are formed by using the patterning process, precision of alignment between the deflecting elements and the 3D display pixels can be high. For example, a deviation in alignment between the deflecting elements and the 3D display pixels may be controlled to be within 1 µm, much better than an alignment deviation of about 10 µm in other processes. As such, crosstalk between the pixels can be reduced, and display effect of the display can be optimized.

In some embodiments, the deflecting element may be a diffractive element, for example, a grating. In this embodiment, the deflecting element deflects incident light in a form of diffraction. Light that is obtained through deflection performed by the deflecting element may be referred to as "deflected light" or "diffracted light". A plane on which the incident light and the diffracted light are located is referred to as a "deflection plane" of the deflection.

In some other embodiments, the deflecting element may be a refractive element, for example, a prism. In this embodiment, the deflecting element deflects incident light in a form of refraction. Light that is obtained through deflection performed by the deflecting element may be referred to as "deflected light" or "refracted light". A plane on which the incident light and the refracted light are located is referred to as a "deflection plane" or "refraction plane" of the deflection.

It should be noted that in this specification, orientations or positional relationships indicated by terms "upper", "lower", "left", "right", "front", "back", and the like are based on orientations or positional relationships shown in the accompanying drawings. These terms are merely for ease and brevity of description of this application rather than indicating or implying that the apparatuses or components mentioned must have specific orientations or must be constructed or manipulated in specific orientations, and therefore shall not be construed as limitations on this application.

The following describes a specific embodiment of the display 101 provided in this application. As described above, in this embodiment of this application, the display 101 may include, in a thickness direction, a display layer 10, a touch layer 20, a glass cover plate 30, and the like that are stacked from bottom to top. For functions of the touch layer 20 and the glass cover plate 30, refer to the foregoing descriptions, and details are not described again. The following focuses on a structure of the display layer 10 provided in this embodiment of this application.

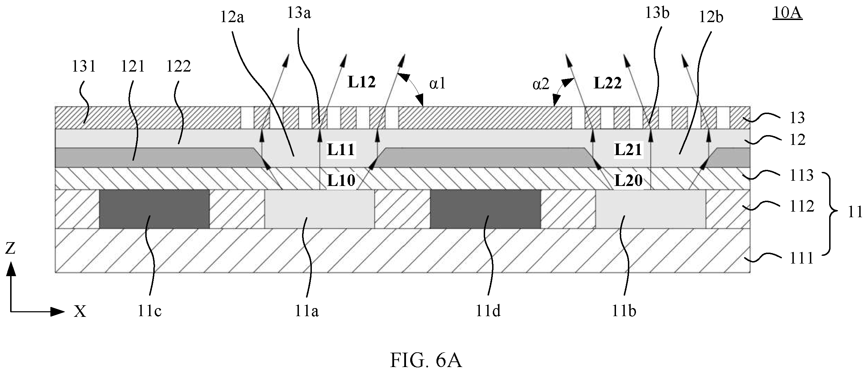

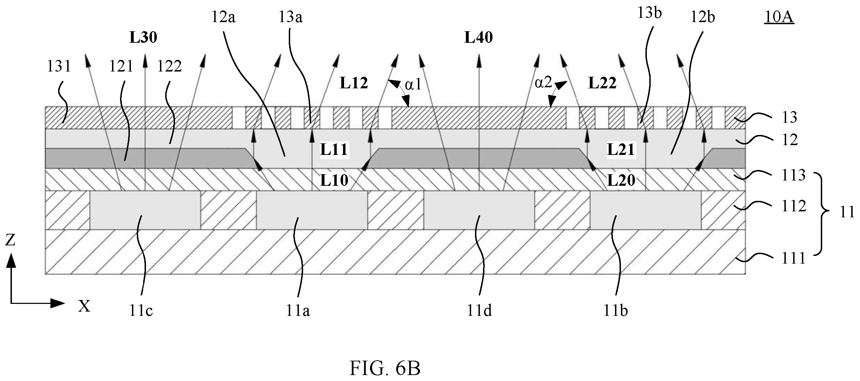

FIG. 6A and FIG. 6B show an example structure of a display layer 10A according to an embodiment of this application. In FIG. 6A, a display 101 is in 3D display mode. In FIG. 6B, the display 101 is in 2D display mode.

With reference to FIG. 6A and FIG. 6B, the display layer 10A includes, in a thickness direction, a display panel 11, a collimation layer 12, and a deflecting element layer 13 that are stacked sequentially from bottom to top. The display panel 11 may be parallel to an X-Y plane, and may include a TFT substrate layer 111, a pixel layer 112, and a package layer 113 that are stacked sequentially. The TFT substrate layer 111 is configured to control the pixel layer 112, for example, control pixels at the pixel layer 112 to be on or off (that is, to emit light or not to emit light), and control colors and luminance of light emitted by the pixels. The pixel layer 112 is configured to emit corresponding light under control of the TFT substrate layer 111. The package layer 113 is configured to package the display panel 11, and may provide insulation between the display panel 11 and other layers.

The display panel 11 includes 3D display pixels (referred to as "3D pixels" for short) and 2D display pixels (referred to as "2D pixels" for short). The 3D pixels include a pixel 11a (as a first display pixel) and a pixel 11b (as a second display pixel). The 2D pixels include a pixel 11c (as a third display pixel) and a pixel 11d (as a fourth display pixel). The 2D display pixels are configured to display a 2D image, while the 3D are configured to display a 3D image. In the following descriptions, an example is used for description, in which the pixel 11a and the pixel 11b display a left-eye image and a right-eye image, respectively. However, it may be understood that in another embodiment, the pixel 11a may be configured to display a right-eye image, while the pixel 11b may be configured to display a left-eye image.

The display panel 11 may be an organic light-emitting diode (organic light-emitting diode, OLED) panel. In another embodiment, the display panel 11 may alternatively be an active-matrix organic light-emitting diode (active-matrix organic light-emitting diode, AMOLED) panel, a liquid crystal display panel, or the like. This is not limited in this embodiment.

The collimation layer 12 is configured to collimate light emitted by the pixel 11a and the pixel 11b. Considering that the light L10 emitted by the pixel 11a and the light L20 emitted by the pixel 11b may both be scattered light, the scattered light L10 and L20 may be respectively converted into parallel light L11 and L21 after being collimated by the collimation layer 12. With reference to FIG. 6, the collimation layer 12 may include a collimating lens 12a (as an example of a first collimating element) and a collimating lens 12b (as an example of a second collimating element). The collimating lens 12a is disposed above the pixel 11a, and configured to collimate the light L10 into the parallel light L11 (or referred to as "collimated light L11"). The collimating lens 12b is disposed above the pixel 11b, and configured to collimate the light L20 into the parallel light L21 (or referred to as "collimated light L21"). In another embodiment, the collimating element may be alternatively implemented by another element other than a collimating lens (or referred to as a "microlens"), for example, a collimating film.

With reference to FIG. 6A and FIG. 6B, in some embodiments, the collimation layer 12 is configured to collimate, along a normal direction of the display panel 11 (that is, a Z-axis direction), the light emitted by the pixel 11a and the pixel 11b. In other words, directions of the parallel light L11 and L21 are both parallel to the Z-axis direction. This can simplify an optical path, facilitating subsequent disposing of the deflecting element layer 13.

Then, the deflecting element layer 13 may refract the collimated light L11 and L12. Specifically, the deflecting element layer 13 includes a grating 13a (as a first deflecting element) and a grating 13b (as a second deflecting element). The grating 13a and grating 13b may both be nano-diffractive gratings. The grating 13a is configured to perform first diffraction (as an example of first deflection) on the collimated light L11, to diffract the collimated light L11 into light L12 (or referred to as "diffracted light L12"). The grating 13b is configured to perform second diffraction (as an example of second deflection) on the collimated light L21, to diffract the collimated light L21 into light L22 (or referred to as "diffracted light L22").

A direction of the diffracted light L12 obtained through the first diffraction is different from that of the diffracted light L22 obtained through the second diffraction. For example, when a user watches an electronic device, the first diffraction causes the diffracted light L12 to be incident on the left eye of the user, and the second diffraction causes the diffracted light L22 to be able to be incident on the right eye of the user. In this way, the display 101 presents a glasses-free 3D image. Based on this, the directions of the diffracted light L12 and L22 are not specifically limited in this embodiment of this application. The directions of the diffracted light L12 and L22 may be determined based on specific use requirements, for example, based on an angle between the pixel 11a/pixel 11b and the left eye/right eye of a user during the user's use of an electronic device.

In some embodiments, a deflection plane of the first diffraction and a deflection plane of the second diffraction are parallel to each other or overlap each other. With reference to FIG. 6A and FIG. 6B, the deflection plane of the first diffraction (that is, a plane on which the collimated light L11 and the diffracted light L12 are located) and the deflection plane of the second diffraction (that is, a plane on which the collimated light L21 and the diffracted light L22 are located) may both be parallel to an X-Z plane. In other words, the collimated light L11 and L21 and the diffracted light L12 and L22 may all be parallel to the X-Z plane. It may be understood that, when the pixel 11a and the pixel 11b are aligned in an X-axis direction, the deflection plane of the first diffraction and the deflection plane of the second diffraction overlap each other.

Further, the first diffraction causes the collimated light L11 to deflect from the Z-axis direction towards the X-axis direction. In other words, the diffracted light L12 obtained through the first diffraction is located between the Z-axis direction and the X-axis direction. For example, between the Z-axis direction and the X-axis direction, the diffracted light L12 is at an angle of α1 to the X-axis direction. The second diffraction causes the collimated light L21 to deflect from the Z-axis direction towards a negative direction of an X-axis. In other words, the diffracted light L22 obtained through the second diffraction is located between the Z-axis direction and the negative direction of the X-axis. For example, between the Z-axis direction and the negative direction of the X-axis, the diffracted light L22 is at an angle of α2 to the negative direction of the X-axis. It may be understood that α1 and α2 are both acute angles, and α1 and α2 may be equal or unequal.

In some other embodiments, the deflection plane of the first diffraction and the deflection plane of the second diffraction may alternatively be other planes. This is not limited in this application.

It may be understood that specific directions of the diffracted light L12 and L22 may be determined by diffraction properties of the gratings. The diffraction properties of the gratings are related to periods, strip directions, and materials of the gratings. Therefore, the grating 13a and the grating 13b can have specific diffraction properties by adjusting periods, strip directions, and/or materials of the grating 13a and the grating 13b, so that the diffracted light L12 and L22 have set directions, to implement glasses-free 3D display effect of the display 101.

In some embodiments, the grating 13a and the grating 13b are transmissive gratings. When the grating 13a and the grating 13b are set as transmissive gratings, a loss of light can be reduced, and light output efficiency of the display 101 can be improved. For example, when the grating 13a and the grating 13b are set as transmissive gratings, the light output efficiency of the display 101 can reach at least 90%.

In this embodiment of this application, the materials of the grating 13a and the grating 13b are materials supporting formation that is implemented by using a patterning process. As described above, the patterning process can implement formation on a quite thin film. Therefore, thicknesses of the grating 13a and the grating 13b can be quite small, reducing a thickness of the display layer 10A and an overall thickness of an electronic device. For example, the thickness of the display layer 10A is reduced to about 0.1 µm to 10 µm.

In addition, the patterning process has high production precision. When the deflecting elements are formed by using the patterning process, precision of alignment between the grating 13a and the pixel 11a and between the grating 13b and the pixel 11b can be high. For example, an alignment deviation may be controlled to be within 1 µm. As such, crosstalk between the pixels can be reduced, and display effect of the display 101 can be improved.

The following describes an example process of producing the display 101 provided in this embodiment.

For example, the process of producing the display 101 may be as follows: obtaining an OLED display panel 11, and then forming a collimation layer 12 on the OLED panel 11. In some embodiments, a material of the collimation layer 12 is also a material supporting formation that is implemented by using the patterning process. For example, the collimation layer 12 includes a light-transmitting film 121 and a light-transmitting film 122 that covers the light-transmitting film 121. Materials of the light-transmitting film 121 and the light-transmitting film 122 are both materials supporting formation that is implemented by using the patterning process. For example, the material of the light-transmitting film 121 may be silicon nitride or a silicon oxide, and the material of the light-transmitting film 122 may be epoxy resin, acrylic resin, or the like. The light-transmitting film 121 and the light-transmitting film 122 have different refractive indices. For example, a refractive index of the light-transmitting film 121 is lower than that of the light-transmitting film 122. Collimation effect of the collimation layer 12 can be implemented by adjusting the refractive indices and shapes of the light-transmitting film 121 and the light-transmitting film 122.

Then, a deflecting element layer 13 may be formed on the collimation layer 12 by using the patterning process. Specifically, a light-transmitting film 131 (for example, silicon nitride, a silicon oxide, or epoxy resin) is applied on the collimation layer 12, and set grating strips are etched on the light-transmitting film 131 by using the patterning process. In this way, a grating 13a and a grating 13b can be formed.

In some embodiments, the OLED display panel 11 and the collimation layer 12 may be alternatively supplied as an integrated piece. To be specific, the OLED display panel 11 and the collimation layer 12 may be procured as a single integrated component. Then, after the grating 13a and the grating 13b are formed on the collimation layer 12 by using the patterning process, a display layer 10A is formed. According to this embodiment, the process of producing the display 101 can be further simplified.

Still with reference to FIG. 6A and FIG. 6B, the display 101 provided in this embodiment of this application includes both 2D pixels and 3D pixels, to implement a 2D/3D switchover function of the display 101.

For example, with reference to FIG. 6A, the pixel 11a and the pixel 11b (that is, 3D pixels) are controlled to be on, while the pixel 11c and the pixel 11d (that is, 2D pixels) are controlled to be off. In this case, the display 101 is in 3D display mode. Image light from the pixel 11a can be incident on the left eye of a user, and an image from the pixel 11b can be incident on the right eye of the user. In this way, the user observes the 3D display effect. With reference to FIG. 6B, the pixel 11a, the pixel 11b, the pixel 11c, and the pixel 11d are all controlled to be on. In this case, light L30 emitted by the pixel 11c and emerging out of the display 101 and light L40 emitted by the pixel 11d and emerging out of the display 101 are both scattered light (that is, light diverging in a plurality of directions), and the display 101 is in 2D display mode. In this way, the user can observe 2D display effect.

In addition, to improve the display effect, the 2D display pixels and the 3D display pixels may be alternately disposed sequentially. For example, the pixel 11c, the pixel 11a, the pixel 11d, and the pixel 11b are arranged sequentially in the X-axis direction. However, it may be understood that in some embodiments, the display 101 may not include the 2D display pixels but includes only the 3D display pixels. In this embodiment, the display 101 may be dedicated to 3D display, without providing 2D display.

It should be noted that for ease of understanding, FIG. 6A and FIG. 6B may show only some of pixels of the display panel 11. The display panel 11 may actually include more pixels. For example, the display panel 11 includes the pixel array shown in FIG. 3 or FIG. 4.

The following describes specific display manners, corresponding to different pixel array manners, of the display 101 provided in this embodiment.

### (1) A pixel array is a strip array.

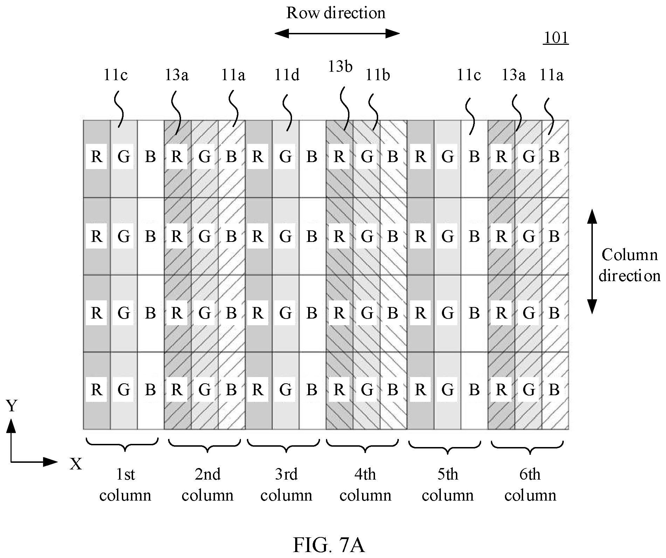

With reference to FIG. 7A, in the strip array, 2D pixels (including pixels 11c and pixels 11d) and 3D pixels (including pixels 11a and pixels 11b) may be disposed alternately along a row direction of the pixel array (an X-axis direction shown in the figure, as a third direction). For example, the pixels in a 1st, 3rd, and 5th columns are 2D pixels, while the pixels in a 2nd, 4th, and 6th columns are 3D pixels. In addition, for the 3D pixels, the pixels 11a (that is, left-eye pixels) and the pixels 11b (that is, right-eye pixels) are disposed alternately along the row direction. For example, the pixels in the 2nd and 6th columns are the left-eye pixels 11a, while the pixels in the 4th column are the right-eye pixels 11b. As described above, gratings 13a are disposed above the pixels 11a, to diffract light emitted by the pixels 11a to the left eye of a user, and gratings 13b are disposed above the pixels 11b, to diffract light emitted by the pixels 11b to the right eye of the user.

When the 2D pixels are turned off but the 3D pixels are turned on, the display 101 is in 3D display mode. In this case, because half of the pixels in the X-axis direction are turned off, resolution of the display 101 in the X-axis direction is reduced by half, but there is no loss of resolution in a Y-axis direction. Therefore, a landscape orientation is suitable for an electronic device in this case.

When both the 2D pixels and the 3D pixels are turned on, the display 101 is in 2D display mode. In this case, there is no loss of resolution of the display 101 in each direction. However, after the light emitted by the 3D pixels is diffracted by the gratings, there is a specific loss of luminance (for example, a loss of 10% of luminance). Therefore, when the display 101 is in 2D display mode, light-emitting intensity of the 3D pixels may be increased by using an algorithm, to compensate for the luminance loss caused by diffraction performed by the gratings. Alternatively, when the display 101 has ultra-high resolution or pixels per inch (Pixels Per Inch, PPI), the 3D pixels may be turned off for 2D display, to simplify an algorithm and reduce power consumption of the display 101.

### (2) A pixel array is a delta array.

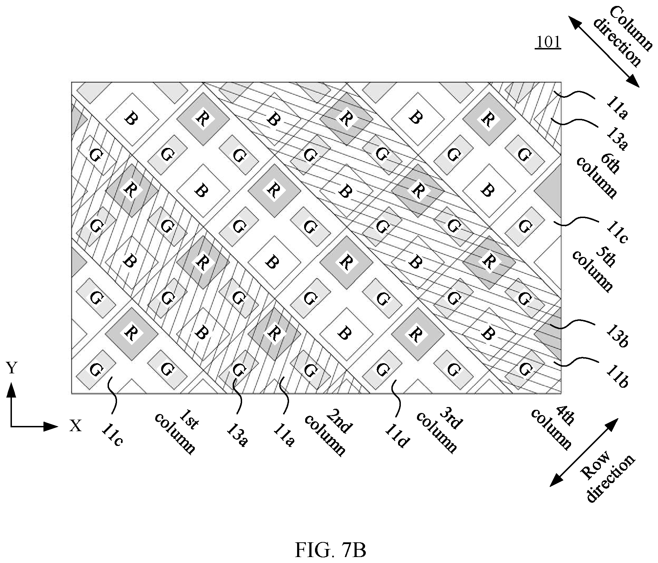

With reference to FIG. 7B, in the delta array, a manner of disposing pixels is similar to that in the strip array. To be specific, 2D pixels and 3D pixels may also be disposed alternately along a column direction of the pixels. For example, the pixels in a 1st, 3rd, and 5th columns are 2D pixels, while the pixels in a 2nd, 4th, and 6th columns are 3D pixels. The pixels in the 2nd and 6th columns are left-eye pixels 11a, while the pixels in the 4th column are right-eye pixels 11b. In addition, gratings 13a are disposed above the pixels 11a, to diffract light emitted by the pixels 11a to the left eye of a user, and gratings 13b are disposed above the pixels 11b, to diffract light emitted by the pixels 11b to the right eye of the user.

However, in the delta array, a row direction of pixel arrangement (as a third direction) is at an angle of 45° to each of an X-axis direction and a Y-axis direction. Therefore, when the 2D pixels are turned off but the 3D pixels are turned on to make the display 101 be in 3D display mode, resolution of the display 101 in the Y-axis direction and resolution of the display 101 in the X-axis direction are both reduced by half. In this case, both a landscape orientation and a portrait orientation are suitable for an electronic device.

In addition, similar to the strip array, when both the 2D pixels and the 3D pixels are turned on, the display 101 is in 2D display mode. In this case, there is no loss of resolution of the display 101 in each direction, but there is a specific loss of luminance of the light emitted by the 3D pixels. Therefore, light-emitting intensity of the 3D pixels may be increased by using an algorithm, to compensate for the luminance loss caused by diffraction performed by the gratings. Alternatively, when the display 101 has ultra-high resolution or PPI, the 3D pixels may be turned off for 2D display, to simplify an algorithm and reduce power consumption of the display 101.

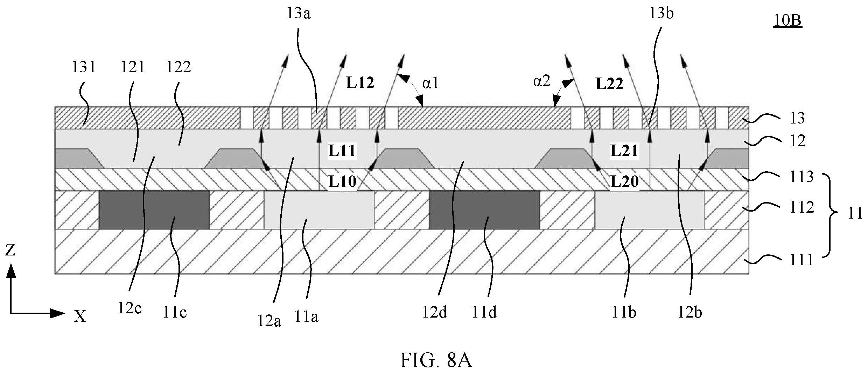

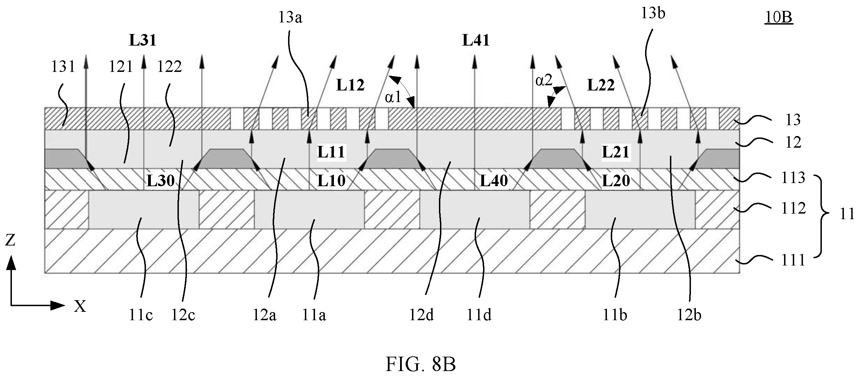

FIG. 8A and FIG. 8B show an example structure of a display layer 10B according to another embodiment of this application. In FIG. 8A, a display 101 is in 3D display mode. In FIG. 8B, the display 101 is in 2D display mode. The display layer 10B differs from the display layer 10A shown in FIG. 6A and FIG. 6B in the following: In the display layer 10B, a collimation layer 12 may collimate not only light emitted by 3D pixels but also light emitted by 2D pixels.

With reference to FIG. 8A and FIG. 8B, in the display layer 10B, the collimation layer 12 includes a collimating lens 12c and a collimating lens 12d in addition to a collimating lens 12a and a collimating lens 12b. The collimating lens 12c is disposed above a pixel 11c, and configured to collimate light L30 emitted by the pixel 11c into parallel light L31 (or referred to as "collimated light L31"). The collimating lens 12d is disposed above a pixel 11d, and configured to collimate light L40 emitted by the pixel 11d into parallel light L41 (or referred to as "collimated light L41"). Therefore, the light emitted by the pixel 11c and emerging out of the display 101 (that is, the collimated light L41) and the light emitted by the pixel 11d and emerging out of the display 101 (that is, the collimated light L41) are light that is parallel to each other. For example, directions of the collimated light L31 and L41 are both parallel to a normal direction of a display panel 11, that is, a Z-axis direction. In another embodiment, a collimating element may be alternatively implemented by a collimating film.

In this embodiment, collimating elements are disposed above the 2D pixels, to collimate, into parallel light, light emitted by the 2D pixels and emerging out of the display 101. In this way, anti-peeping effect of the display 101 is implemented. For example, a user can see content on the display 101 only when facing the display 101. When the user is at another angle, it is difficult to clearly see the content on the display 101.

Except for that, other structures and a variant of the display layer 10B are essentially the same as those of the display layer 10A. For example, a disposing manner of a deflecting element layer 13 of the display layer 10B is essentially the same as that of the display layer 10A. Therefore, refer to the foregoing descriptions about the display layer 10A. Details are not described again.

In addition, it may be understood that similar to the display layer 10A, the display layer 10B can also switch between 2D and 3D. For example, with reference to FIG. 8A, a pixel 11a and a pixel 11b (that is, 3D pixels) are controlled to be on, while the pixel 11c and the pixel 11d (that is, 2D pixels) are controlled to be off. In this case, the display 101 is in 3D display mode, and a user can observe 3D display effect. With reference to FIG. 8B, the pixel 11a, the pixel 11b, the pixel 11c, and the pixel 11d are all controlled to be on. In this case, the display 101 is in 2D display mode, and the user can observe 2D display effect.

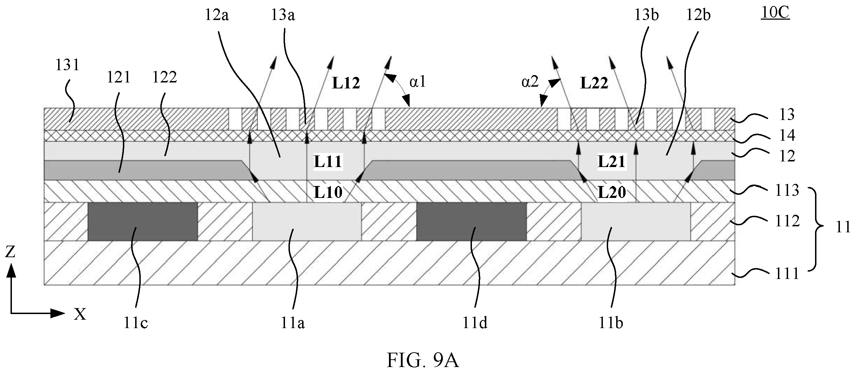

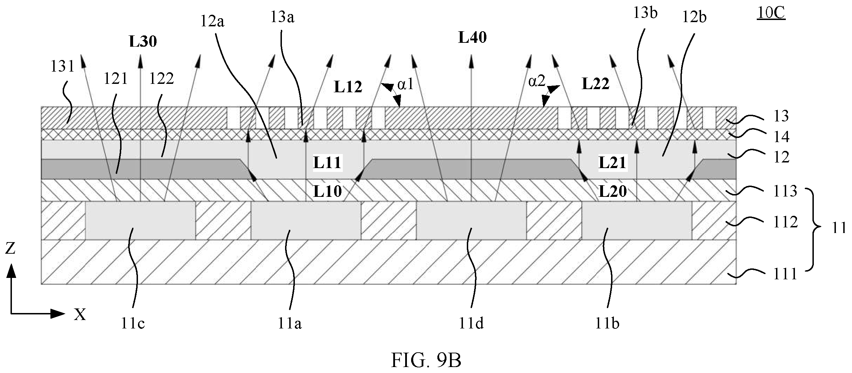

FIG. 9A and FIG. 9B show an example structure of a display layer 10C according to still another embodiment of this application. In FIG. 9A, a display 101 is in 3D display mode. In FIG. 9B, the display 101 is in 2D display mode. The display layer 10C differs from the display layer 10A shown in FIG. 6A and FIG. 6B in the following: In the display layer 10C, a deflecting element layer 13 is not formed directly on a collimation layer 12, but is stuck to the collimation layer 12 by using an adhesive layer 14.

With reference to FIG. 9A and FIG. 9B, the display layer 10 includes the adhesive layer 14, in addition to a display panel 11, the collimation layer 12, and the deflecting element layer 13. The adhesive layer 14 is provided between the deflecting element layer 13 and the collimation layer 12, configured to stick the deflecting element layer 13 to the collimation layer 12. A material of the adhesive layer 14 may be optical clear adhesive (Optical Clear Adhesive, OCA).

In this embodiment, the deflecting element layer 13 may be produced independently as a single component. For example, after a light-transmitting film 131 is produced independently, grating strips are etched on the light-transmitting film 131 by using a patterning process, to form a grating 13a and a grating 13b. Then, the deflecting element layer 13 is stuck to the collimation layer 12 by using the adhesive layer 14. In this way, the display layer 10C can be formed.

In this embodiment, the deflecting element layer 13 may be produced independently, simplifying a process of producing the deflecting element layer 13. However, due to addition of the adhesive layer, a thickness of the display layer 10C increases slightly. In addition, when the deflecting element layer 13 is stuck to the collimation layer 12, difficulty of aligning the grating 13a and the grating 13b with a pixel 11a and a pixel 11b of the display panel 11 may be slightly higher than that in the solution for the display layer 10A.

Except for that, other structures and a variant of the display layer 10C are essentially the same as those of the display layer 10A. For example, a disposing manner of the deflecting element layer 13 of the display layer 10B is essentially the same as that of the display layer 10A, and the display layer 10B can also switch between 2D and 3D. Therefore, refer to the foregoing descriptions about the display layer 10A. Details are not described again.

In addition, in some embodiments, collimating elements may also be disposed above 2D pixels of the display panel 11 of the display layer 10C, to implement anti-peeping effect of the display 101. In some other embodiments, there may be no collimating elements disposed above 2D pixels of the display panel 11 of the display layer 10C, to expand a viewing angle of the display 101.

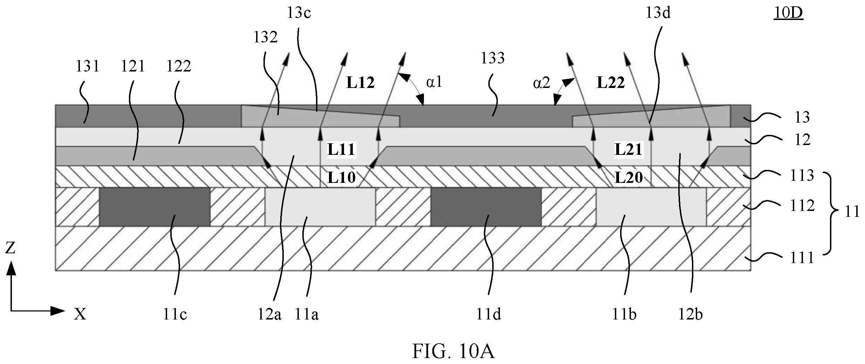

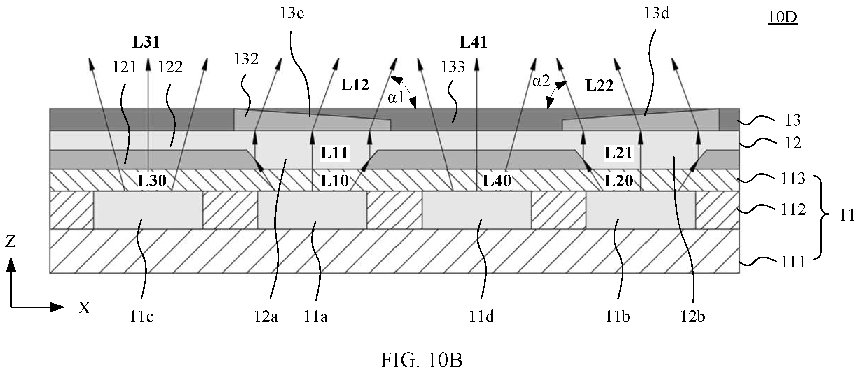

FIG. 10A and FIG. 10B show an example structure of a display layer 10D according to still another embodiment of this application. In FIG. 10A, a display 101 is in 3D display mode. In FIG. 10B, the display 101 is in 2D display mode. The display layer 10D differs from the display layer 10A shown in FIG. 6A and FIG. 6B in the following: In the display layer 10D, refractive elements in a deflecting element layer 13 are prisms, which replace gratings.

With reference to FIG. 10A and FIG. 10B, the deflecting element layer 13 in the display layer 10D includes a prism 13c and a prism 13d. The prism 13c is configured to replace the grating 13a in the display layer 10A. To be specific, the prism 13c is configured to perform first refraction (as an example of first deflection) on collimated light L11, to refract the collimated light L11 into light L12. The prism 13d is configured to replace the grating 13b in the display layer 10A. To be specific, the prism 13d is configured to perform second refraction (as an example of second deflection) on collimated light L21, to refract the collimated light L21 into light L22. The refraction performed by the prism 13c and the refraction performed by the prism 13d can enable the display 101 to implement glasses-free 3D display effect. For a direction of refracted light obtained through the first refraction (that is, the light L12) and a direction of refracted light obtained through the second refraction (that is, the light L22), refer to the directions of the diffracted light L12 and the diffracted light L22 in the foregoing descriptions about the display layer 10A, respectively. Details are not described again.

Materials of the prism 13c and the prism 13d are also materials supporting formation that is implemented by using a patterning process. To be specific, the prism 13c and the prism 13d may be formed by using the patterning process. In this way, overall thicknesses of the display layer 10 and an electronic device are reduced, and precision of alignment between the prism 13c and a pixel 11a and between the prism 13d and a pixel 11b is improved.

For example, with reference to FIG. 10A and FIG. 10B, the deflecting element layer 13 includes a light-transmitting film 132 and a light-transmitting film 133 that covers the light-transmitting film 132. Materials of the light-transmitting film 132 and the light-transmitting film 133 are both materials supporting formation that is implemented by using the patterning process. For example, the material of the light-transmitting film 132 may be epoxy resin or acrylic resin, and the material of the light-transmitting film 133 may be silicon nitride, a silicon oxide, or the like. The light-transmitting film 132 and the light-transmitting film 133 have different refractive indices. For example, a refractive index of the light-transmitting film 132 is lower than that of the light-transmitting film 133. The prism 13c and the prism 13d with set refractive indices can be formed by adjusting the refractive indices and shapes of the light-transmitting film 132 and the light-transmitting film 132.

Except that the grating 13a and the grating 13b are respectively replaced with the prism 13c and the prism 13d, other structures and a variant of the display layer 10D are essentially the same as those of the display layer 10A. For example, a disposing manner of the deflecting element layer 13 of the display layer 10D is essentially the same as that of the display layer 10A, and the display layer 10D can also switch between 2D and 3D. Therefore, refer to the foregoing descriptions about the display layer 10A. Details are not described again.

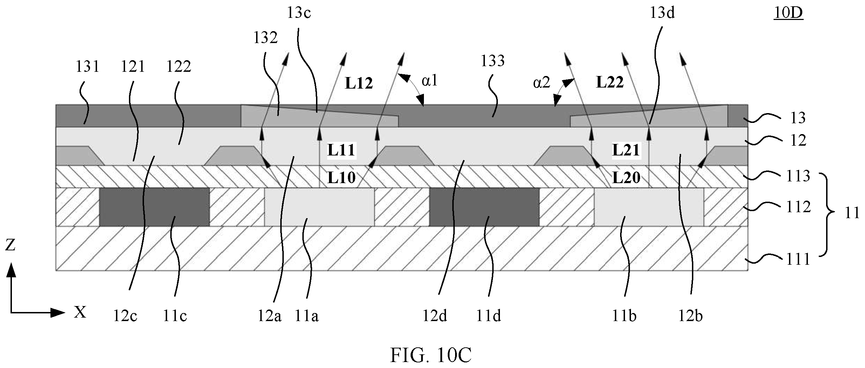

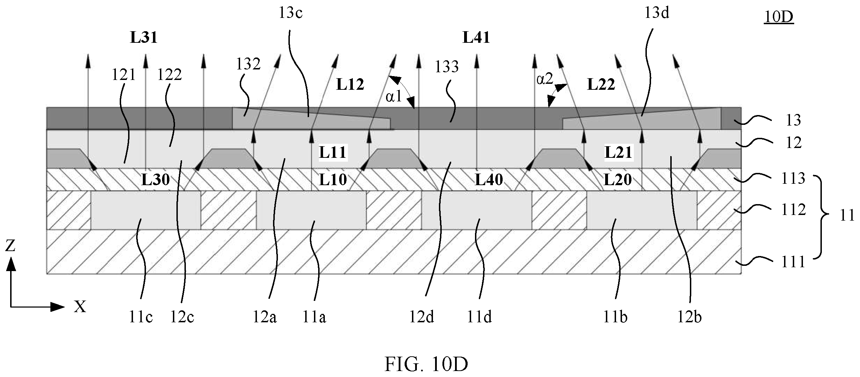

In the embodiment shown in FIG. 10A and FIG. 10B, no collimating elements are disposed above 2D pixels (that is, a pixel 11c and a pixel 11d) of a display panel 11 of the display layer 10D, to expand a viewing angle of the display 101. In some other embodiments, with reference to FIG. 10C and FIG. 10D, collimating elements may also be disposed above 2D pixels of a display panel 11 of the display layer 10D, for example, a collimating lens 12c being disposed above a pixel 11c, and a collimating lens 12d being disposed above a pixel 11d, to implement anti-peeping effect of the display 101.

The following provides comparisons between the display 101 provided in this embodiment of this application and displays provided in some other embodiments.

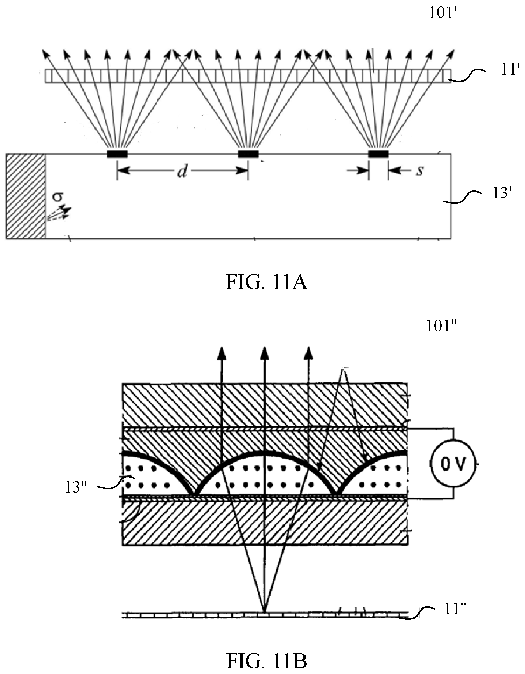

For example, FIG. 11A is a diagram of an example structure of a display 101' according to some embodiments. With reference to FIG. 11A, a display panel 11' of the display 101' is a liquid crystal display (Liquid Crystal Display, LCD) panel 11' without a self-light-emitting function. For a purpose of enabling the display 101' to emit light, the display 101' further includes a backlight module configured to provide light for the LCD panel 11' (not shown). In addition, the display 101' further includes a nano-diffractive grating that is disposed between the backlight module and the LCD panel 11'. Light emitted by the backlight module is first diffracted by the nano-diffractive grating, and then emerges out of the liquid crystal display panel 11'. When angles at which the nano-diffractive grating diffracts the light are controlled, light from left-eye pixels of the display panel 11' can be incident on the left eye of a user, and light from right-eye pixels of the display panel 11' can be incident on the right eye of the user, implementing glasses-free 3D display effect of the display 101'.

When the display 101' in an example shown in FIG. 11A is compared with the display 101 provided in this embodiment of this application, the nano-diffractive grating needs to be added between the backlight module and the LCD panel 11'. The disposing results in that the display 101' has a large thickness. In addition, 3D light output efficiency of the nano-diffractive grating is low, resulting in a significant loss of resolution of the display 101'.

For another example, FIG. 11B is a diagram of an example structure of a display 101" according to some other embodiments. With reference to FIG. 11B, the display 101" includes an organic light-emitting diode (Organic Light-Emitting Diode, OLED) display panel 11" and a liquid crystal lens 13". After being refracted by the liquid crystal lens", light emitted by the OLED panel" is incident on eyes of a person. When a refractive index of the liquid crystal lens 13" is controlled, light from left-eye pixels of the display panel 11" can be incident on the left eye of a user, and light from right-eye pixels of the display panel 11" can be incident on the right eye of the user, implementing glasses-free 3D display effect.

When the display 101" in an example shown in FIG. 11B is compared with the display 101 provided in this embodiment of this application, presence of the liquid crystal lens 13" results in that an overall thickness of the display 101" is excessively large. In addition, when the display 101" performs 3D display, a loss of luminance of the display 101" is close to half. Furthermore, when a pixel array of the display panel 11" is a strip array (the array shown in FIG. 3), 2D display effect of the display 101" is affected.

In the foregoing descriptions of this embodiment, "/" means "or" unless otherwise specified. For example, A/B may indicate A or B. In this specification, "and/or" is merely an association describing associated objects, indicating that three relationships may exist. For example, A and/or B may indicate the following three cases: Only A exists, only B exists, and both A and B exist.

## Claims

1. A display, comprising:
a display panel, wherein the display panel comprises at least a first display pixel and a second display pixel;
a collimation layer, wherein the collimation layer is stacked on the display panel in a first direction, and configured to collimate light emitted by the first display pixel into first collimated light and light emitted by the second display pixel into second collimated light; and
a first deflecting element and a second deflecting element, wherein the first deflecting element is stacked on the collimation layer in the first direction and configured to perform first deflection on the first collimated light, the second deflecting element is stacked on the collimation layer in the first direction and configured to perform second deflection on the second collimated light, and a deflected light direction of the first deflection is different from that of the second deflection; and
materials of the first deflecting element and the second deflecting element are materials supporting formation that is implemented by using a patterning process.

2. The display according to claim 1, wherein the collimation layer is configured to collimate, along the first direction, the light emitted by the first display pixel and the second display pixel.

3. The display according to claim 1 or 2, wherein a deflection plane of the first deflection and a deflection plane of the second deflection overlap each other or are parallel to each other.

4. The display according to claim 2, wherein the first deflection causes the first collimated light to deviate from the first direction towards a second direction, the second deflection causes the second collimated light to deviate from the first direction towards a direction opposite the second direction, and the second direction is perpendicular to the first direction and parallel to a deflection plane of the first deflection.

5. The display according to claim 1, wherein the display panel further comprises a third display pixel and a fourth display pixel; the first display pixel, the second display pixel, the third display pixel, and the fourth display pixel are aligned in a third direction; and the third direction is perpendicular to the first direction, wherein
light emitted by the third display pixel and the fourth display pixel and emerging out of the display is scattered light; or
the collimation layer is further configured to collimate light emitted by the third display pixel and the fourth display pixel, so that the light emitted by the third display pixel and the fourth display pixel and emerging out of the display is parallel light that is parallel to each other.

6. The display according to claim 5, wherein the first display pixel, the third display pixel, the second display pixel, and the fourth display pixel are arranged sequentially in the third direction.

7. The display according to claim 6, wherein a deflection plane of the first deflection and a deflection plane of the second deflection overlap each other or are parallel to each other; and
the third direction is parallel to the deflection plane of the first deflection, or the third direction is at an angle of 45° to the deflection plane of the first deflection.

8. The display according to claim 1, wherein a material of the collimation layer is a material supporting formation that is implemented by using the patterning process.

9. The display according to claim 1, wherein the collimation layer comprises a first collimating element and a second collimating element, and the collimation layer collimates the light emitted by the first display pixel by using the first collimating element, and collimates the light emitted by the first display pixel by using the second collimating element.

10. The display according to claim 9, wherein the first collimating element and the second collimating element are collimating lenses, or the first collimating element and the second collimating element are collimating films.

11. The display according to claim 1, wherein the first deflecting element and the second deflecting element are diffractive elements, or the first deflecting element and the second deflecting element are refractive elements.

12. The display according to claim 11, wherein the diffractive element is a grating, and the refractive element is a prism.

13. The display according to claim 12, wherein the grating is a transmissive grating.

14. The display according to claim 1, wherein the display panel is an organic light-emitting diode OLED panel.

15. An electronic device, comprising a housing and the display according to any one of claims 1 to 14, wherein the display is disposed on the housing.
